# EUROPEAN PATENT APPLICATION

(11) **EP 4 415 502 A1**
(43) Date of publication of application: **14.08.2024**
(21) Application number: 23826532.6
(22) Date of filing: 21.06.2023
(51) Int. Cl.: H10K 59/00, G06F 3/041

(54) **DISPLAY PANEL AND DISPLAY DEVICE**

(30) Priority: 23.06.2022 CN 202210723269
(71) Applicant: BOE TECHNOLOGY GROUP CO., LTD., Beijing 100015 (CN); Chengdu BOE Optoelectronics Technology Co., Ltd., Chengdu, Sichuan 611731 (CN)
(72) Inventor: TONG, Kemeng, Beijing 100176 (CN); YAN, Jun, Beijing 100176 (CN); HE, Fan, Beijing 100176 (CN); DONG, Xiangdan, Beijing 100176 (CN); LEE, Ansu, Beijing 100176 (CN); DU, Mengmeng, Beijing 100176 (CN); LIU, Tingliang, Beijing 100176 (CN); ZHANG, Wei, Beijing 100176 (CN); QIU, Haijun, Beijing 100176 (CN); HU, Ming, Beijing 100176 (CN); ZHAO, Yongliang, Beijing 100176 (CN); JIANG, Zhiliang, Beijing 100176 (CN); SONG, Gukhwan, Beijing 100176 (CN); WANG, Rui, Beijing 100176 (CN); XIE, Taofeng, Beijing 100176 (CN); ZHENG, Hai, Beijing 100176 (CN); ZHANG, Yi, Beijing 100176 (CN); JI, Fengli, Beijing 100176 (CN); QING, Haigang, Beijing 100176 (CN); YAN, Zhenglong, Beijing 100176 (CN)
(74) Representative: Cohausz & Florack
(86) International application number: PCT/CN2023/101783
(87) International publication number: WO 2023/246887

(57) **Abstract**

The present disclosure provides a display panel and a display device. The display panel comprises a display area and a non-display area located on one side of the display area, the non-display area comprising a bending area, a binding area, and a wiring area located between the bending area and the binding area. The display panel comprises: a base substrate; and a touch structure located on the base substrate, the touch structure comprising a touch lead, the touch lead being led out from the display area and extending to the binding area, the touch lead comprising a first lead located in the bending area and a second lead located in the wiring area, the first lead and the second lead being electrically connected and located on different metal layers, and the second lead using a single-layer metal wire.

## Description

### Cross-Reference to Related Applications

The present application claims priority to Chinese Patent Application No. 202210723269.7, filed with the China National Intellectual Property Administration on June 23, 2022 and entitled "Display Panel and Display Device", the entire contents of which are hereby incorporated by reference.

### Technical Field

The present disclosure relates to the field of touch display technology, and in particular to a display panel and a display device.

### Background

With the continuous development of electronic products, the OLED (Organic Light Emitting Diode) display devices have been widely used because they can achieve the full screen, narrow frame, high resolution, rollable wear, folding, etc. With the technology (Flexible Multi-Layer On Cell, FMLOC) of fabricating a touch structure directly on an encapsulation layer of an OLED (Organic Light Emitting Diode) display panel, a lighter and thinner display device may be produced. This technology may be applied to foldable and rollable OLED display devices.

### Summary

Embodiments of the present disclosure provide a display panel and a display device. The solutions are as follows.

Embodiments of the present disclosure provide a display panel, including a display area and a non-display area on a side of the display area. The non-display area includes a bending area, a bonding area, and a wiring area between the bending area and the bonding area.

The display panel includes:
a base substrate; and
a touch structure on the base substrate.

The touch structure includes a touch lead led out from the display area and extending to the bonding area. The touch lead includes a first lead in the bending area and a second lead in the wiring area. The first lead and the second lead are electrically connected and located in different metal layers. The second lead is made of a single-layer metal wire.

In possible implementations, the above display panel provided by the embodiments of the present disclosure further includes a first metal layer, a first planarization layer, a second metal layer, a second planarization layer, a third metal layer and a third planarization layer stacked in sequence between the base substrate and the touch structure. The first metal layer is close to the base substrate.

The touch structure further includes a first insulating layer, a first touch electrode layer, a second insulating layer and a second touch electrode layer located at least in the display area and stacked in sequence on a side of the third planarization layer facing away from the base substrate.

The first insulating layer and the second insulating layer are organic layers. The first lead is in the second metal layer.

In possible implementations, in the above display panel provided by the embodiments of the present disclosure, the touch lead further includes a third lead led out from the display area and extending to a side of the bending area away from the bonding area. The third lead includes a first sub-lead in the first touch electrode layer and a second sub-lead in the second touch electrode layer. The first sub-lead and the second sub-lead are electrically connected through a via hole penetrating the second insulating layer.

In possible implementations, in the above display panel provided by the embodiments of the present disclosure, the non-display area further includes a transition area between the display area and the bending area. A part of the transition area close to the bending area is a first transfer hole area, and a part of the wiring area close to the bending area is a second transfer hole area.

The first sub-lead is electrically connected to a first lap-joint portion located in the third metal layer through a via hole penetrating the third planarization layer in the first transfer hole area. The first lap-joint portion is electrically connected to the first lead through a via hole penetrating the second planarization layer in the first transfer hole area.

In possible implementations, in the above display panel provided by the embodiments of the present disclosure, the via hole for electrical connection between the first sub-lead and the second sub-lead does not overlap with the first transfer hole area.

In possible implementations, in the above display panel provided by the embodiments of the present disclosure, the second lead is in the third metal layer, and the second lead is electrically connected to the first lead through a via hole penetrating the second planarization layer in the second transfer hole area.

In possible implementations, in the above display panel provided by the embodiments of the present disclosure, an orthographic projection of the first touch electrode layer in the wiring area at most covers an orthographic projection of a part of the wiring area close to the bonding area. An orthographic projection of the second touch electrode layer in the wiring area at most covers the orthographic projection of the part of the wiring area close to the bonding area.

In a possible implementation, in the above display panel provided by the embodiments of the present disclosure, an orthographic projection of the first touch electrode layer on the base substrate does not overlap with an orthographic projection of the bending area on the base substrate. An orthographic projection of the second touch electrode layer on the base substrate does not overlap with the orthographic projection of the bending area on the base substrate.

In possible implementations, in the above display panel provided by the embodiments of the present disclosure, the second lead is in the first touch electrode layer. The second lead is electrically connected to a second lap-joint portion in the third metal layer through a via hole penetrating the first insulating layer and the third planarization layer in the second transfer hole area. The second lap-joint portion is electrically connected to the first lead through a via hole penetrating the second planarization layer in the second transfer hole area.

In possible implementations, in the above display panel provided by the embodiments of the present disclosure, an orthographic projection of the first touch electrode layer on the base substrate does not overlap with an orthographic projection of the bending area on the base substrate. An orthographic projection of the second touch electrode layer on the base substrate does not overlap with the orthographic projection of the bending area on the base substrate. An orthographic projection of the second touch electrode layer in the wiring area at most covers an orthographic projection of a part of the wiring area close to the bonding area.

In possible implementations, in the above display panel provided by the embodiments of the present disclosure, the second lead is in the second touch electrode layer. The second lead is electrically connected to a second lap-joint portion in the third metal layer through a via hole penetrating the second insulating layer. The first insulating layer and the third planarization layer in the second transfer hole area. The second lap-joint portion is electrically connected to the first lead through a via hole penetrating the second planarization layer in the second transfer hole area.

In possible implementations, in the above display panel provided by the embodiments of the present disclosure, an orthographic projection of the second touch electrode layer on the base substrate does not overlap with an orthographic projection of the bending area on the base substrate. An orthographic projection of the first touch electrode layer on the base substrate does not overlap with the orthographic projection of the bending area on the base substrate. An orthographic projection of the first touch electrode layer in the wiring area at most covers an orthographic projection of a part of the wiring area close to the bonding area.

In possible implementations, in the above display panel provided by the embodiments of the present disclosure, an orthographic projection of the second insulating layer on the base substrate does not overlap with an orthographic projection of the bending area on the base substrate. The orthographic projection of the second insulating layer on the base substrate overlaps with orthographic projections of the display area, the wiring area and the bonding area on the base substrate.

In possible implementations, in the above display panel provided by the embodiments of the present disclosure, an orthographic projection of the first insulating layer on the base substrate does not overlap with an orthographic projection of the bending area on the base substrate. The orthographic projection of the first insulating layer on the base substrate overlaps with orthographic projections of the display area, the wiring area and the bonding area on the base substrate.

In possible implementations, the above display panel provided by the embodiments of the present disclosure further includes a low-voltage power line and a high-voltage power line. The low-voltage power line and the high-voltage power line in the bending area are both made of single-layer metal wires in the second metal layer. The metal wires of the low-voltage power line and/or the high-voltage power line in the bending area are located on both sides of the first lead and spaced apart from the first lead.

The low-voltage power line and the second lead overlap with each other in the wiring area.

In possible implementations, the above display panel provided by the embodiments of the present disclosure further includes a low-voltage power line and a high-voltage power line. The low-voltage power line includes a first conductive structure and a second conductive structure in the wiring area. The first conductive structure is in the first metal layer. The second conductive structure is in the second metal layer. The first conductive structure is electrically connected to the second conductive structure through a via hole penetrating the first planarization layer.

The high-voltage power line includes a third conductive structure and a fourth conductive structure in the wiring area. The third conductive structure is located in the first metal layer and spaced apart from the first conductive structure. The fourth conductive structure is in the second metal layer and spaced apart from the second conductive structure. The third conductive structure is electrically connected to the fourth conductive structure through a via hole penetrating the first planarization layer.

In possible implementations, in the above display panel provided by the embodiments of the present disclosure, the low-voltage power line further includes a fifth conductive structure in the wiring area. The fifth conductive structure is in the third metal layer. The fifth conductive structure is electrically connected to the second conductive structure through a via hole penetrating the second planarization layer.

The high-voltage power line further includes a sixth conductive structure in the wiring area. The sixth conductive structure is in the third metal layer and spaced apart from the fifth conductive structure. The sixth conductive structure is electrically connected to the fourth conductive structure through a via hole penetrating the second planarization layer.

The second lead is insulated from the fifth conductive structure and the sixth conductive structure.

In possible implementations, in the above display panel provided by the embodiments of the present disclosure, the fifth conductive structure includes two sub-conductive structures spaced apart from each other, and the second lead is between the two sub-conductive structures.

In possible implementations, the above display panel provided by the embodiments of the present disclosure further includes a protective layer on a side of the touch structure facing away from the base substrate. An orthographic projection of the protective layer on the base substrate does not overlap with an orthographic projection of the bending area on the base substrate.

In possible implementations, the above display panel provided by the embodiments of the present disclosure further includes: a display structure between the third planarization layer and the touch structure, and an encapsulation structure between the display structure and the touch structure.

The display structure includes an anode layer, a pixel definition layer, a light-emitting functional layer and a cathode layer stacked in sequence between the third planarization layer and the encapsulation structure.

The display panel further includes a spacer layer disposed between the pixel definition layer and the cathode layer.

The encapsulation structure includes a first inorganic encapsulation layer, a first organic encapsulation layer, a second inorganic encapsulation layer, a second organic encapsulation layer and a third inorganic encapsulation layer stacked.

In possible implementations, in the above display panel provided by the embodiments of the present disclosure, the first planarization layer, the second planarization layer, the third planarization layer and the spacer layer all cover the bending area.

Correspondingly, embodiments of the present disclosure further provide a display device, including the above display panel provided by the embodiments of the present disclosure.

### Brief Description of Figures

FIG. 1 is a schematic diagram of a planar structure of a display panel according to an embodiment of the present disclosure.
FIG. 2 is a schematic cross-sectional view of one light-emitting sub-pixel in FIG. 1.
FIG. 3A is a schematic diagram of the layout in parts of the bending area and bonding area in FIG. 1.
FIG. 3B is a schematic cross-sectional view in the dotted box E1 in FIG. 3A.
FIG. 3C is a schematic cross-sectional view along the direction FF' in FIG. 3A.
FIG. 4A is a schematic diagram of the layout in parts of the bending area and bonding area in FIG. 1.
FIG. 4B is a schematic cross-sectional view in the dotted box E1 in FIG. 4A.
FIG. 4C is a schematic cross-sectional view along the direction FF' in FIG. 4A.
FIG. 4D is a schematic diagram of a top-view structure of the VDD, VSS and the second lead in the wiring area.
FIG. 5A is a schematic diagram of the layout in parts of the bending area and bonding area in FIG. 1.
FIG. 5B is a schematic cross-sectional view in the dotted box E1 in FIG. 5A.
FIG. 5C is a schematic cross-sectional view along the direction FF' in FIG. 5A.
FIG. 6A is a schematic diagram of the layout in parts of the bending area and bonding area in FIG. 1.
FIG. 6B is a schematic cross-sectional view in the dotted box E1 in FIG. 6A.
FIG. 6C is a schematic cross-sectional view along the direction FF' in FIG. 6A.
FIG. 7A is a schematic cross-sectional view in the dotted box E1 in FIG. 3A.
FIG. 7B is a schematic cross-sectional view along the direction FF' in FIG. 3A.
FIG. 7C is a schematic plan view of the touch leads using double-layer wiring of the first touch electrode layer and the second touch electrode layer in the wiring area.
FIG. 8 is a schematic diagram of the boundaries of the first insulating layer and the second insulating layer corresponding to FIG. 4A, FIG. 4C, FIG. 5A, FIG. 5C, FIG. 6A, FIG. 6C, FIG. 7A and FIG. 7C on the upper and lower sides of the bending area.
FIG. 9 is an enlarged schematic diagram of some pads and touch leads electrically connected thereto in FIG. 4A.
FIG. 10 is an enlarged schematic diagram of some pads and touch leads electrically connected thereto in FIG. 5A.
FIG. 11 is an enlarged schematic diagram of some pads 8 and touch leads electrically connected thereto in FIG. 6A.
FIG. 12 is a schematic diagram of a planar structure of a display device according to an embodiment of the present disclosure.

### Detailed Description

In order to make the purposes, technical solutions and advantages of the present disclosure clearer, the technical solutions of the embodiments of the present disclosure will be described clearly and completely below in combination with the accompanying drawings of the embodiments of the present disclosure. Obviously the described embodiments are a part of the embodiments of the present disclosure but not all the embodiments. Also in the case of no conflict, the embodiments and the features therein in the present disclosure can be combined with each other. Based upon the embodiments of the present disclosure, all of other embodiments obtained by those ordinary skilled in the art without creative work pertain to the protection scope of the present disclosure.

Unless otherwise defined, the technical or scientific terms used in the present disclosure shall have the general meaning understood by those ordinary skilled in the art to which the present disclosure belongs. The word such as "include" or "contain" or the like used in the present disclosure means that the element or object appearing before this word encompasses the elements or objects and their equivalents listed after this word, without excluding other elements or objects. The word such as "connect" or "connected" or the like is not limited to the physical or mechanical connection, but can include the electrical connection, whether direct or indirect. The words such as "inner", "outer", "up", "down" are only used to represent the relative position relationship. When the absolute position of a described object changes, the relative position relationship may also change accordingly.

It is necessary to note that the size and shape of each diagram in the accompanying drawings do not reflect the true proportion, and are merely for purpose of schematically illustrating the content of the present disclosure. Also, the same or similar reference numbers represent the same or similar elements or the elements having the same or similar functions all the way.

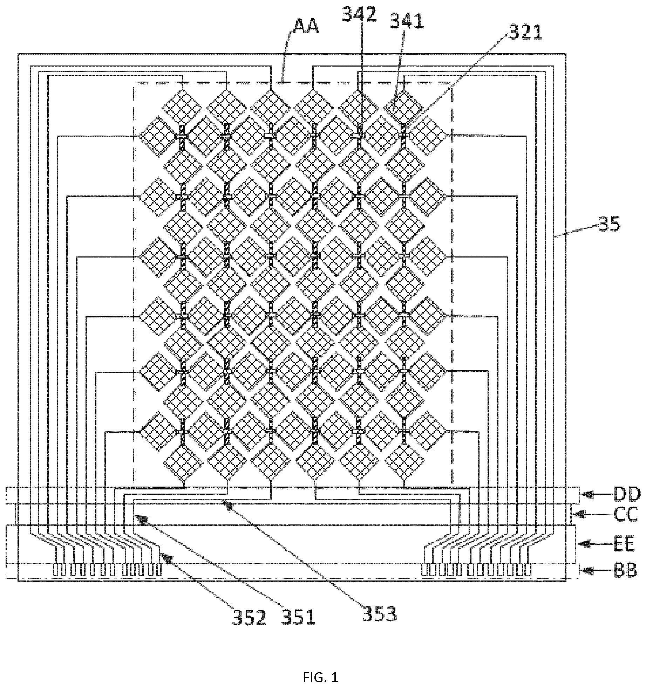

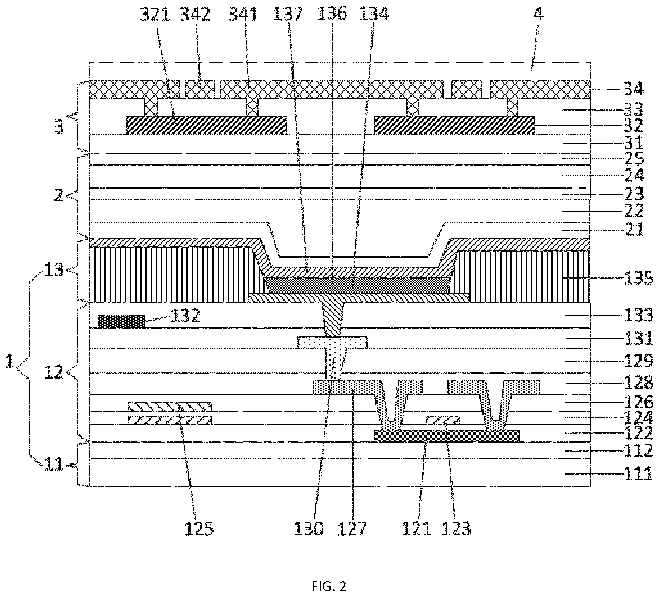

As shown in FIGS. 1 and 2, FIG. 1 is a schematic diagram of a planar structure of an OLED display panel after touch electrodes are arranged thereon. This display panel includes: a display area AA and a non-display area located on one side of the display area AA. The non-display area AA includes a bending area CC, a bonding area BB, and a wiring area EE located between the bending area CC and the bonding area BB. The display area AA generally includes a plurality of light-emitting sub-pixels. As shown in FIG. 2, FIG. 2 is a schematic cross-sectional view of one light-emitting sub-pixel in FIG. 1. This display panel includes a display substrate 1, an encapsulation structure 2 for encapsulating the display substrate 1, a touch structure 3 located on the encapsulation structure 2, and a protective layer 4 located on the touch structure 3. Here, the touch structure 3 is directly fabricated on the encapsulation structure 2. This technology is called the FMLOC technology, which can be used to produce lighter and thinner touch panels and can be applied to foldable and rollable OLED display devices.

As shown in FIG. 2, the display substrate 1 includes: a base substrate 11, a drive circuit 12 and a display structure 13 that are stacked in sequence between the base substrate 11 and the encapsulation structure 2. Optionally, the base substrate 11 may include a polyimide layer 111 and a buffer layer 112 that are stacked in sequence. The drive circuit 12 may include an active layer 121, a first gate insulating layer 122, a first gate metal layer 123, a second gate insulating layer 124, a second gate metal layer 125, an interlayer dielectric layer 126, a first metal layer 127 (first Source Drain metal layer, SD1 for short), a passivation layer 128, a first planarization layer 129, a second metal layer 130 (second Source Drain metal layer, SD2 for short), a second planarization layer 131, a third metal layer 132 (third Source Drain metal layer, SD3 for short) and a third planarization layers 133 that are stacked in sequence on the base substrate 11. The display structure 13 may include an anode layer 134, a pixel definition layer 135, a light-emitting functional layer 136 and a cathode layer 137 that are stacked in sequence between the drive circuit 12 and the encapsulation structure 2. Here the anode layer 134 may be electrically connected to the first metal layer 127 through the second metal layer 130.

Specifically, the first metal layer 127 is generally provided with a source electrode, a drain electrode, a data lines, etc.. The second metal layer 130 is generally provided as an intermediate electrode that lap-joints the anode layer 134 and the drain electrode. The third metal layer 132 is based on the FIAA technology used by the project of narrow frame products. With the FIAA technology, the third metal layer 132 and the third planarization layer 133 are added. The third metal layer 132 is mainly used for data signal wiring in the fanout area to achieve the narrow frame design of the lower frame.

With the rapid development of the OLED, people's demand for four-sided bendable mobile phones is increasing, and the process challenges are also increasing. In order to meet the stress requirement of large-angle bending, the inorganic film layer in the FMLOC process is replaced with an organic film layer. As shown in FIG. 2, the touch structure 3 includes a first insulating layer 31, a first touch electrode layer 32, a second insulating layer 33 and a second touch electrode layer 34 stacked. Both the first insulating layer 31 and the second insulating layer 33 are organic layers. Optionally, the first touch electrode layer 32 may include a plurality of bridge electrodes 321, and the second touch electrode layer 34 may include a plurality of touch electrodes 341, where some touch electrodes 341 are directly connected through the connection parts 342 located in the second touch electrode layer 34, and the other touch electrodes 341 are electrically connected through the bridge electrodes 321 located in the first touch electrode layer 32, to achieve Tx touch electrodes and Rx touch electrodes.

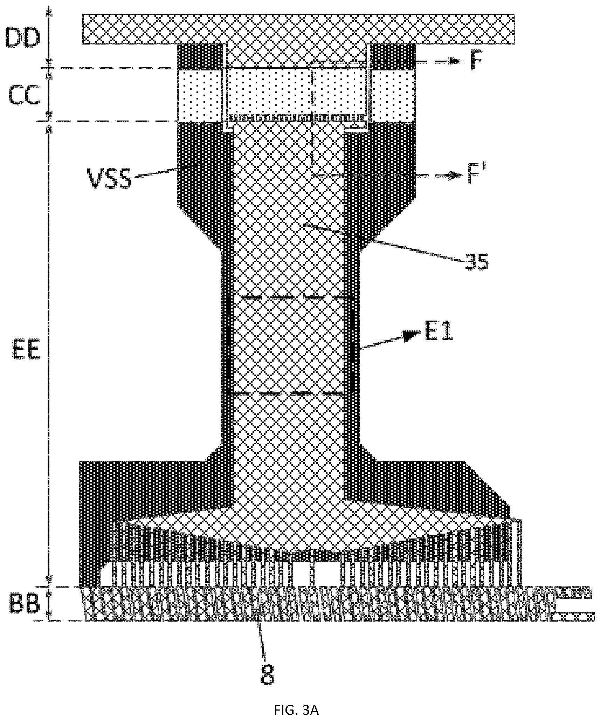

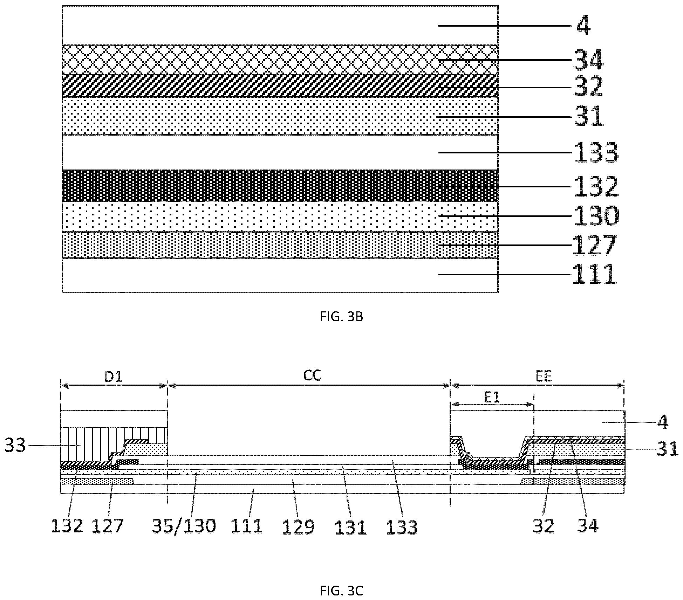

As shown in FIG. 1, the touch structure 3 further includes touch leads 35 electrically connected to the touch electrodes 341. The touch leads 35 extend from the display area AA to the bonding area BB. As shown in FIGS. 3A to 3C, FIG. 3A is a schematic diagram of the layout in parts of the bending area CC, wiring area EE and bonding area BB in FIG. 1, FIG. 3B is a schematic cross-sectional view in the dotted box E1 in FIG. 3A, and FIG. 3C is a schematic cross-sectional view along the direction FF' in FIG. 3A. The part of the touch lead 35 located in the display area AA and between the display area AA and the bending area CC is generally made of the double-layer metal wire (the double-layer metal wire located in the first touch electrode layer 32 and the second touch electrode layer 34, where the two layers of wires are electrically connected through a via hole to reduce resistance). The part of the touch lead 35 located in the bending area CC is generally jumped to the second metal layer 130. The part of the touch lead 35 located in the bonding area BB is further jumped to the first touch electrode layer 32 and the second touch electrode layer 34, and the second insulating layer 33 in the bonding area BB is removed, that is, the touch lead 35 in the bonding area BB is made of two layers of wires which are in direct contact and electrically connected, to further reduce the resistance. The second insulating layer 33 in the bonding area BB is removed. Since the organic first insulating layer 31 has poor etching resistance and easily absorbs water, the surface of the organic first insulating layer 31 will be made rough and uneven during the etching process for the first touch electrode layer 32. When the second touch electrode layer 34 is deposited, the second touch electrode layer 34 may polymerize with the organic first insulating layer 31, resulting in incomplete etching of the second touch electrode layer 34, causing the problem of metal remain, and thus causing the short (short circuit) problem of adjacent touch leads 35 in the bonding area BB.

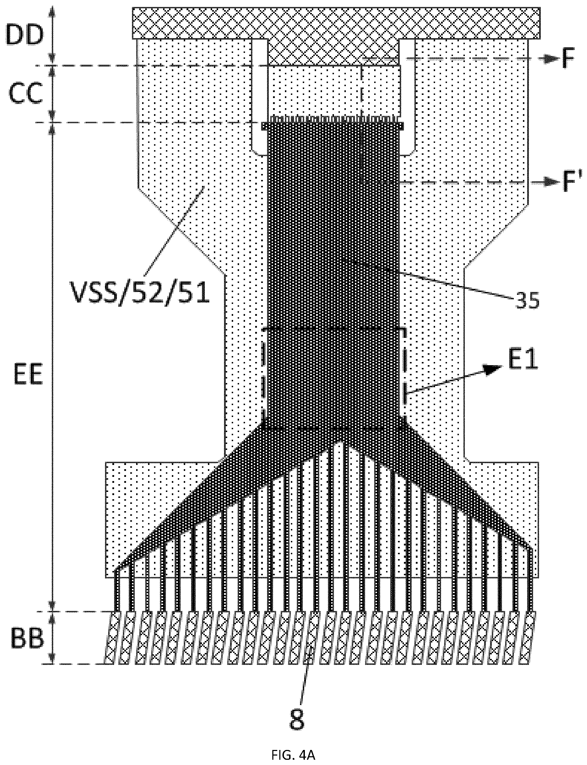

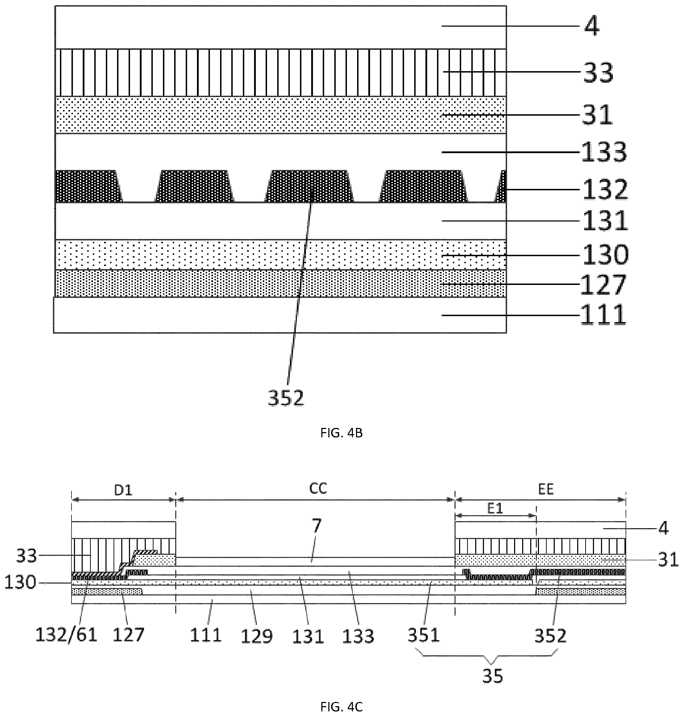

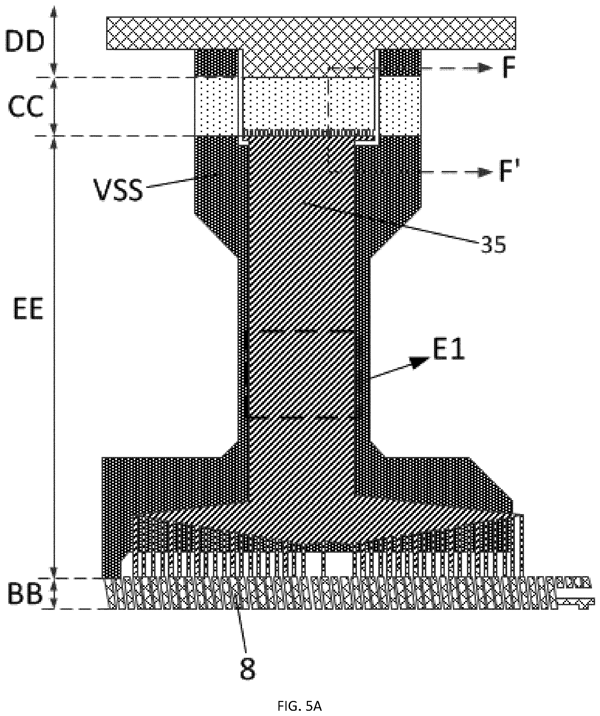

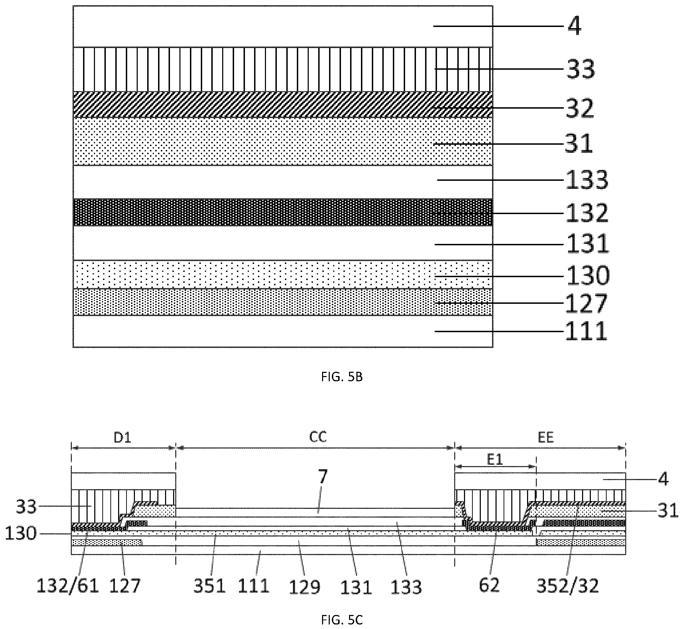

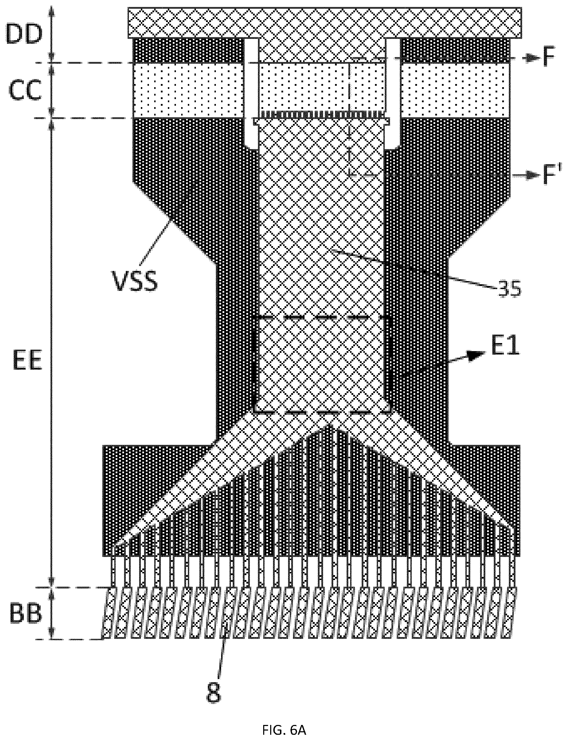

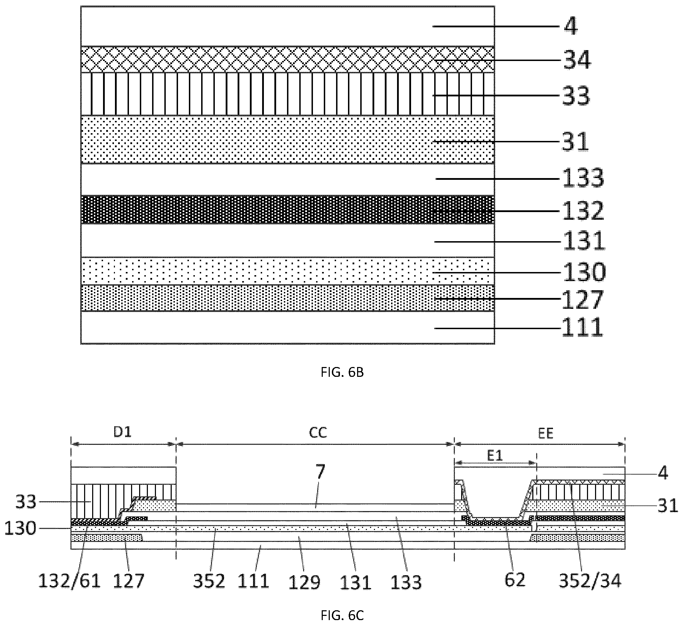

In order to solve the above problems, the present disclosure provides a display panel, as shown in FIGS. 1, 2 and 4A to 6C. FIG. 4A is a schematic diagram of the layout in parts of the bending area CC and bonding area BB in FIG. 1, FIG. 4B is a schematic cross-sectional view in the dotted box E1 in FIG. 4A, FIG. 4C is a schematic cross-sectional view along the direction FF' in FIG. 4A, FIG. 5A is a schematic diagram of the layout in parts of the bending area CC and bonding area BB in FIG. 1, FIG. 5B is a schematic cross-sectional view in the dotted box E1 in FIG. 5A, FIG. 5C is a schematic cross-sectional view along the direction FF' in FIG. 5A, FIG. 6A is a schematic diagram of the layout in parts of the bending area CC and bonding area BB in FIG. 1, FIG. 6B is a schematic cross-sectional view in the dotted box E1 in FIG. 6A, and FIG. 6C is a schematic cross-sectional view along the direction FF' in FIG. 6A. The display panel includes: a display area AA and a non-display area located on one side of the display area AA. The non-display area AA includes a bending area CC, a bonding area BB, and a wiring area EE located between the bending area CC and the bonding area BB.

The display panel AA includes
a base substrate 11; and
a touch structure 3 located on the base substrate 11.

The touch structure 3 includes a touch lead 35 led out from the display area AA and extending to the bonding area BB. The touch lead 35 includes a first lead 351 located in the bending area CC and a second lead 352 located in the wiring area EE. The first lead 351 and the second lead 352 are electrically connected and located in different metal layers, and the second lead 352 is made of a single-layer metal wire.

In the above display panel provided by the embodiments of the present disclosure, the second lead located in the wiring area is made of the single-layer metal wire, so that the arrangement of a corresponding insulating layer above or below the film layer where the second lead is located can avoid the short problem of adjacent touch leads in the wiring area due to the metal remain in the solution shown in FIGS. 3A to 3C.

During implementations, in the above display panel provided by the embodiments of the present disclosure, as shown in FIGS. 1, 2 and 4A to 6C, the display panel further includes a first metal layer 127, a first planarization layer 129, a second metal layer 130, a second planarization layer 131, a third metal layer 132 and a third planarization layer 133 stacked in sequence between the base substrate 11 and the touch structure 3. The first metal layer 127 is close to the base substrate 11. Optionally, the first metal layer 127 may be an SD1 layer, the second metal layer 130 may be an SD2 layer, and the third metal layer 132 may be an SD3 layer. Here, the SD1 layer is generally provided with a source electrode, a drain electrode, a data lines, etc.; the SD2 layer is generally provided as an intermediate electrode that lap-joints the anode layer and the drain electrode; and the SD3 layer is based on the FIAA technology used by the project of narrow frame products. With the FIAA technology, the SD3 layer and third planarization layer 133 are added. The SD3 layer is mainly used for data signal wiring in the fanout areas (bonding area, bending area and transition area). That is, the data lines of the SD1 layer are jumped to the SD3 layer through via holes, so that the area occupied by the signal lines of the SD1 layer in the fanout area can be reduced, thereby achieving the narrow frame design of the lower frame.

During implementations, in the above display panel provided by the embodiments of the present disclosure, as shown in FIGS. 1, 2 and 4A to 6C, the touch structure 3 further includes a first insulating layer 31, a first touch electrode layer 32, a second insulating layer 33 and a second touch electrode layer 34 located at least in the display area AA and stacked in sequence on one side of the third planarization layer 133 facing away from the base substrate 11.

Here, the first insulating layer 31 and the second insulating layer 33 are organic layers. The first lead 351 is located in the second metal layer 130, and the second lead 352 is located in any one of the third metal layer 132, the first touch electrode layer 32 and the second touch electrode layers 34. In this way, the arrangement of the first lead 351 of the bending area CC in the second metal layer 130 can improve the bending performance of the display panel, and the arrangement of the second lead 352 in any one of the third metal layer 132, the first touch electrode layer 32 and the second touch electrode layers 34 can avoid the short problem of adjacent touch leads in the wiring area EE due to the metal remain in the solution shown in FIGS. 3A to 3C.

During implementations, in the above display panel provided by the embodiments of the present disclosure, as shown in FIGS. 1 and 2, the touch lead 35 further includes a third lead 353 (that is, a lead located above the bending area CC) led out from the display area AA and extending to one side of the bending area CC away from the bonding area BB. The third lead 353 includes a first sub-lead (not shown) located in the first touch electrode layer 32 and a second sub-lead (not shown) located in the second touch electrode layer 34. The first sub-lead and the second sub-lead are electrically connected through a via hole penetrating the second insulating layer 33. That is, the third lead 353 of the touch lead 35 located in the display area AA and between the display area AA and the bending area CC is made of the double-layer metal wire of the first touch electrode layer 32 and the second touch electrode layer 34, so as to reduce the resistance.

During implementations, in the above display panel provided by the embodiments of the present disclosure, as shown in FIGS. 1, 4A, 4C, 5A, 5C, 6A and 6C, the non-display area further includes a transition area DD between the display area AA and the bending area CC. A part of the transition area DD close to the bending area CC is a first transfer hole area D1, and a part of the wiring area EE close to the bending area CC is a second transfer hole area E1.

The first sub-lead is electrically connected to a first lap-joint portion 61 located in the third metal layer 132 through a via hole penetrating the third planarization layer 133 in the first transfer hole area D1. The first lap-joint portion 61 is electrically connected to the first lead 351 through a via hole penetrating the second planarization layer 131 in the first transfer hole area D1. That is, this section of touch lead 35 (the third lead 353) led out from the display area AA and extending to the first transfer hole area D1 may adopt double-layer wiring of the first touch electrode layer 32 and the second touch electrode layer 34. When entering the first transfer hole area D1 of the transition area DD, the touch lead 35 is jumped from the first touch electrode layer 32 to the second metal layer 130 through the third metal layer 132, that is, the second metal layer 130 is used to fabricate the touch lead 35 in the bending area CC (i.e., the first lead 351 in the bending area CC). In addition, the first lead 351 may be jumped to any one of the third metal layer 132, the first touch electrode layer 32 and the second touch electrode layer 34 in the second transfer hole area E1.

During implementations, in the above display panel provided by the embodiments of the present disclosure, the via hole for electrical connection between the first sub-lead and the second sub-lead does not overlap with the first transfer hole area. For example, the via hole for electrical connection between the first sub-lead and the second sub-lead is located in the non-display area above the transition area DD. The first sub-lead and the second sub-lead may be electrically connected through a plurality of via holes, to increase the contact area of the first sub-lead and the second sub-lead, and achieve the purpose of further reducing the resistance.

During implementations, in the above display panel provided by the embodiments of the present disclosure, as shown in FIGS. 1, 2 and 4A to 6C, the second lead 352 may be located in the third metal layer 132, so that the second lead 352 may be electrically connected to the first lead 351 through a via hole penetrating the second planarization layer 131 in the second transfer hole area E1. In this way, when the touch structure 3 is subsequently fabricated, the orthographic projection of the first touch electrode layer 32 on the base substrate 11 may be set to not overlap with the orthographic projection of the bending area CC on the base substrate 11, the orthographic projection of the second touch electrode layer 34 on the base substrate 11 may be set to not overlap with the orthographic projection of the bending area CC on the base substrate 11, the orthographic projection of the first touch electrode layer 32 in the wiring area EE may be set to cover at most the orthographic projection of the part of the wiring area EE close to the bonding area BB, and the orthographic projection of the second touch electrode layer 34 in the wiring area EE may be set to cover at most the orthographic projection of the part of the wiring area EE close to the bonding area BB. That is, the first touch electrode layer 32 and the second touch electrode layer 34 located in the bending area CC are completely removed, a part of the first touch electrode layer 32 and a part of the second touch electrode layer 34 located in the wiring area EE are removed, and the touch lead 35 is jumped to the third metal layer 132 (SD3 layer) in the wiring area EE, so as to solve the problem of metal remain due to metal oxidation caused by the fact that the organic first insulating layer 31 and the organic second insulating layer 33 easily absorb water and have poor etching resistance in the solution of FIGS. 3A to 3C.

During implementations, in order to improve the bending performance of the bending area, in the above display panel provided by the embodiments of the present disclosure, as shown in FIGS. 3A to 3C, the orthographic projection of the first insulating layer 31 on the base substrate 11 does not overlap with the orthographic projection of the bending area CC on the base substrate 11, and the orthographic projection of the first insulating layer 31 on the base substrate 11 overlaps with the orthographic projections of the display area AA, the wiring area EE and the bonding area BB on the base substrate 11. The orthographic projection of the second insulating layer 33 on the base substrate 11 does not overlap with the orthographic projection of the bending area CC on the base substrate 11, and the orthographic projection of the second insulating layer 33 on the base substrate 11 overlaps with the orthographic projections of the display area AA, the wiring area EE and the bonding area BB on the base substrate 11. Specifically, the first planarization layer 129, the second planarization layer 131 and the third planarization layer 133 are retained in the bending area CC. In order to make the first lead 351 be located in the neutral layer 2, the first insulating layer 31 and the second insulating layer 33 located in the bending area CC are removed in the embodiments of the present disclosure to prevent the first lead 351 from being broken when bent.

During implementations, in the above display panel provided by the embodiments of the present disclosure, as shown in FIGS. 1, 2 and 5A-5C, the second lead 352 may be located in the first touch electrode layer 32, so that the second lead 352 may be electrically connected to a second lap-joint portion 62 located in the third metal layer 132 through a via hole penetrating the first insulating layer 31 and the third planarization layer 133 in the second transfer hole area E1. The second lap-joint portion 62 is electrically connected to the first lead 351 through a via hole penetrating the second planarization layer 131 in the second transfer hole area E1. Here, the orthographic projection of the first insulating layer 31 on the base substrate 11 does not overlap with the orthographic projection of the bending area CC on the base substrate 11, and the orthographic projection of the first insulating layer 31 on the base substrate 11 overlaps with the orthographic projections of the display area AA, the wiring area EE and the bonding area BB on the base substrate 11. The orthographic projection of the second insulating layer 33 on the base substrate 11 does not overlap with the orthographic projection of the bending area CC on the base substrate 11, and the orthographic projection of the second insulating layer 33 on the base substrate 11 overlaps with the orthographic projections of the display area AA, the wiring area EE and the bonding area BB on the base substrate 11. In this way, when the touch structure 3 is subsequently fabricated, the orthographic projection of the first touch electrode layer 32 on the base substrate 11 may be set to not overlap with the orthographic projection of the bending area CC on the base substrate 11, the orthographic projection of the second touch electrode layer 34 on the base substrate 11 may be set to not overlap with the orthographic projection of the bending area CC on the base substrate 11, and the orthographic projection of the second touch electrode layer 34 in the wiring area EE may be set to cover at most the orthographic projection of the part of the wiring area EE close to the bonding area BB. That is, the second touch electrode layer 34 located in the bending area CC and a part of the second touch electrode layer 34 located in the wiring area EE are removed, so that the first touch electrode layer 32 is used to fabricate the second lead 352 on the first insulating layer 31, and the second insulating layer 33 above the second lead 352 is retained. When the part of the second touch electrode layer 34 above the second insulating layer 33 in the wiring area EE is removed, the retained second insulating layer 33 can prevent the short problem of adjacent second leads 352 due to the etching remain in the second touch electrode layer 34.

Specifically, as shown in FIGS. 5A to 5C, the first planarization layer 129, the second planarization layer 131 and the third planarization layer 133 are retained in the bending area CC. In order to make the first lead 351 be located in the neutral layer 2, the first insulating layer 31 and the second insulating layer 33 located in the bending area CC are removed in the embodiments of the present disclosure to prevent the first lead 351 from being broken when bent.

During implementations, in the above display panel provided by the embodiments of the present disclosure, as shown in FIGS. 1, 2 and 6A-6C, the second lead 352 may be located in the second touch electrode layer 34, and the second lead 352 may be electrically connected to a second lap-joint portion 62 located in the third metal layer 132 through a via hole penetrating the second insulating layer 33, the first insulating layer 31 and the third planarization layer 133 in the second transfer hole area E1. The second lap-joint portion 62 is electrically connected to the first lead 351 through a via hole penetrating the second planarization layer 131 in the second transfer hole area E1. Here, the orthographic projection of the first insulating layer 31 on the base substrate 11 does not overlap with the orthographic projection of the bending area CC on the base substrate 11, and the orthographic projection of the first insulating layer 31 on the base substrate 11 overlaps with the orthographic projections of the display area AA, the wiring area EE and the bonding area BB on the base substrate 11. The orthographic projection of the second insulating layer 33 on the base substrate 11 does not overlap with the orthographic projection of the bending area CC on the base substrate 11, and the orthographic projection of the second insulating layer 33 on the base substrate 11 overlaps with the orthographic projections of the display area AA, the wiring area EE and the bonding area BB on the base substrate 11. In this way, when the touch structure 3 is subsequently fabricated, the orthographic projection of the first touch electrode layer 32 above the first insulating layer 31 on the base substrate 11 may be set to not overlap with the orthographic projection of the bending area CC on the base substrate 11, the orthographic projection of the first touch electrode layer 32 in the wiring area EE may be set to cover at most the orthographic projection of the part of the wiring area EE close to the bonding area BB, and the orthographic projection of the second touch electrode layer 34 on the base substrate 11 may be set to not overlap with the orthographic projection of the bending area CC on the base substrate 11. That is, the first touch electrode layer 32 located in the bending area CC and a part of the first touch electrode layer 32 located in the wiring area EE are removed, and the second insulating layer 33 above the first touch electrode layer 32 is retained. It can be ensured that the second lead 352 is fabricated above the flat second insulating layer 33, thereby preventing the short problem of adjacent second leads 352 due to the etching remain in the second touch electrode layer 34.

Specifically, as shown in FIGS. 6A to 6C, the first planarization layer 129, the second planarization layer 131 and the third planarization layer 133 are retained in the bending area CC. In order to make the first lead 351 be located in the neutral layer 2, the first insulating layer 31 and the second insulating layer 33 located in the bending area CC are removed in the embodiments of the present disclosure to prevent the first lead 351 from being broken when bent.

During implementations, in order to improve the bending performance of the bending area, in the above display panel provided by the embodiments of the present disclosure, as shown in FIGS. 2 and 4A to 6C, the first insulating layer 31 in the embodiments of the present disclosure is token as an organic layer as an example. Of course, the first insulating layer 32 may also be an inorganic layer. Using the first insulating layer 32 being the inorganic layer may reduce the film stack of the organic layers in the bonding area BB. The inorganic layer is not easy to absorb water and resist etching, thereby achieving the purpose of further reducing the metal remain.

During implementations, in order to improve the bending performance of the bending area, the above display panel provided by the embodiments of the present disclosure, as shown in FIGS. 2, 4A, 5A and 6A, further includes a low-voltage power line VSS and a high-voltage power line (not shown). In order to improve the bending performance, both the low-voltage power line VSS and the high-voltage power line are made of the single-layer metal wire located in the second metal layer 130 in the bending area CC, and the metal wire of the low-voltage power line VSS and/or the high-voltage power line in the bending area CC is located on both sides of the first lead 351 and spaced apart from the first lead 351. The low-voltage power line VSS and the second lead 352 overlap with each other in the wiring area EE. In the embodiments of the present disclosure, the metal wire of the low-voltage power line VSS in the bending area CC is located on both sides of the first lead 351 and spaced apart from the first lead 351 as an example.

During implementations, as shown in FIG. 5A and FIG. 6A, since the second lead 352 is made of the touch electrode layer, the high-voltage power line and the low-voltage power line VSS can adopt the three-layer wiring design of the first metal layer 127, the second metal layer 130 and the third metal layer 13 in the wiring area EE, to arrange a conductive structure with reduced resistance.

During implementations, in the above display panel provided by the embodiments of the present disclosure, as shown in FIGS. 2 and 4A, the low-voltage power line VSS includes a first conductive structure 51 and a second conductive structure 52 in the wiring area EE. The first conductive structure 51 may be located in the first metal layer 127. The second conductive structure 52 may be located in the second metal layer 130. The first conductive structure 51 is electrically connected to the second conductive structure 52 through a via hole penetrating the first planarization layer 129. It should be noted that the first conductive structure 51 and the second conductive structure 52 electrically connected are arranged in the wiring area EE, in order to reduce the resistance of the low-voltage power line VSS. The patterns of the first conductive structure 51 and the second conductive structure 52 are the same, and the first conductive structure 51 is covered by the pattern of the second conductive structure 52.

During implementations, in the above display panel provided by the embodiments of the present disclosure, the high-voltage power line corresponding to the structure shown in FIG. 4A may include a third conductive structure and a fourth conductive structure in the wiring area. The third conductive structure may be located in the first metal layer and is spaced apart from the first conductive structure. The fourth conductive structure may be located in the second metal layer and is spaced apart from the second conductive structure. The third conductive structure is electrically connected to the fourth conductive structure through a via hole penetrating the first planarization layer. It should be noted that the third conductive structure and the fourth conductive structure electrically connected are arranged in the wiring area, in order to reduce the resistance of the high-voltage power line. The patterns of the third conductive structure and the fourth conductive structure are the same, and the third conductive structure is covered by the pattern of the fourth conductive structure.

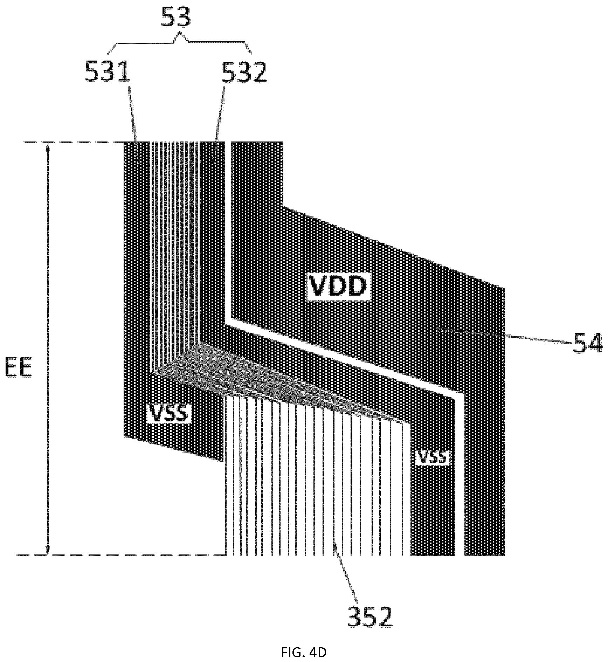

During implementations, in the above display panel provided by the embodiments of the present disclosure, as shown in FIG. 4D, the low-voltage power line VSS further includes a fifth conductive structure 53 in the wiring area EE. The fifth conductive structure 53 is located in the third metal layer 132. The fifth conductive structure 53 is electrically connected to the second conductive structure 52 through a via hole penetrating the second planarization layer 131.

The high-voltage power line VDD further includes a sixth conductive structure 54 in the wiring area EE. The sixth conductive structure 54 is located in the third metal layer 132 and spaced apart from the fifth conductive structure 53. The sixth conductive structure 54 is electrically connected to the fourth conductive structure through a via hole penetrating the second planarization layer 131. It should be noted that the first conductive structure 51, the second conductive structure 52 and the fifth conductive structure 53 electrically connected are arranged in the wiring area EE, in order to further reduce the resistance of the low-voltage power line VSS. The patterns of the first conductive structure 51 and the second conductive structure 52 are the same. The fifth conductive structure 53 covers parts of the first conductive structure 51 and the second conductive structure 52. FIG. 4D only shows the fifth conductive structure 53 and the sixth conductive structure 54 located in the third metal layer 132.

The second lead 352 is insulated from the fifth conductive structure 53 and the sixth conductive structure 54, so that the fifth conductive structure 53, the sixth conductive structure 54 and the second lead 352 do not affect each other.

During implementations, in the above display panel provided by the embodiments of the present disclosure, as shown in FIG. 4D, the fifth conductive structure 53 includes two sub-conductive structures (531 and 532) spaced apart from each other. The second lead 352 is located between the two sub-conductive structures (531 and 532), that is, the orthographic projections of the second lead 352 and the two sub-conductive structures (531 and 532) on the base substrate 11 do not overlap with each other. Specifically, both sub-conductive structures are electrically connected to the second conductive structure 52. By arranging the second lead 352 of the touch lead 35 located in the wiring area EE in the third metal layer 132, the high-voltage power line VDD further including the sixth conductive structure 54 located in the third metal layer 132 in the wiring area EE, and the low-voltage power line VSS further including the fifth conductive structure 53 located in the third metal layer 132 in the wiring area EE, the high-voltage power line VDD, the low-voltage power line VSS and the second lead 352 do not affect each other on the basis of further reducing the resistances of the high-voltage power line VDD and the low-voltage power line VSS.

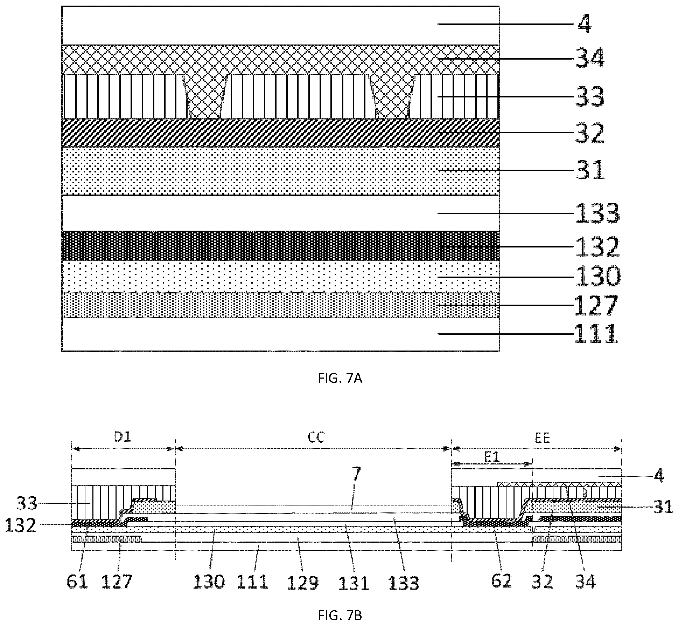

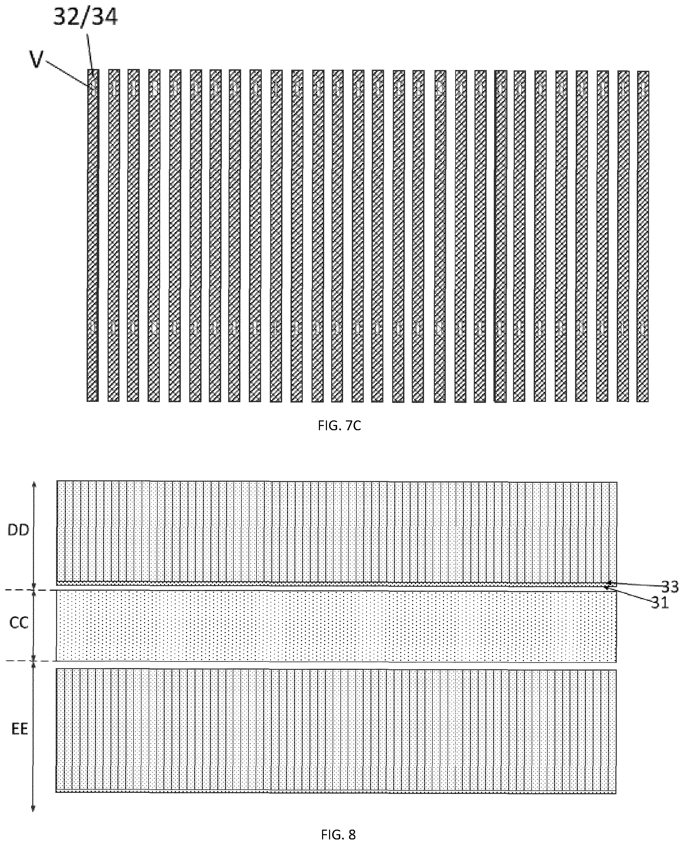

During implementations, in the above display panel provided by the embodiments of the present disclosure, as shown in FIGS. 2 and 7A to 7C, FIG. 7A is a schematic cross-sectional view in the dotted box E1 in FIG. 3A, FIG. 7B is a schematic cross-sectional view along the direction FF' in FIG. 3A, and FIG. 7C is a schematic plan view of the touch lead 35 using double-layer wiring of the first touch electrode layer 32 and the second touch electrode layer 34 in the wiring area EE. The second insulating layer 33 between the first touch electrode layer 32 and the second touch electrode layer 34 is retained in the wiring area EE, and the part of the touch lead 35 in the wiring area EE is electrically connected through the via hole V penetrating the second insulating layer 33, so that the second insulating layer 33 retained in the wiring area EE can allow the second touch electrode layer 34 to be deposited on the planarization layer substrate, to prevent the polymerization reaction between the second touch electrode layer 34 and the organic first insulating layer 31 that causes the problem of metal remain when the second touch electrode layer 34 is etched and thus causes the short (short circuit) problem of adjacent touch leads 35 in the bonding area BB.

Specifically, as shown in FIGS. 1 and 7B, the orthographic projection of the first insulating layer 31 on the base substrate 11 does not overlap with the orthographic projection of the bending area CC on the base substrate 11. The orthographic projection of the first insulating layer 31 on the base substrate 11 overlaps with the orthographic projections of the display area AA, the wiring area EE and the bonding area BB on the base substrate 11. The orthographic projection of the second insulating layer 33 on the base substrate 11 does not overlap with the orthographic projection of the bending area CC on the base substrate 11, and the orthographic projection of the second insulating layer 33 on the base substrate 11 overlaps with the orthographic projections of the display area AA, the wiring area EE and the bonding area BB on the base substrate 11.

It should be noted that "overlap with" mentioned in the embodiments of the present disclosure may include complete overlap and partial overlap.

During implementations, the above display panel provided by the embodiments of the present disclosure, as shown in FIGS. 2, 4B, 4C, 5B, 5C, 6B, 6C, 7A and 7B, further includes a protective layer 4 located on one side of the touch structure 3 facing away from the base substrate 11. The orthographic projection of the protective layer 4 on the base substrate 11 does not overlap with the orthographic projection of the bending area CC on the base substrate 11. Optionally, the protective layer 4 may be an organic layer, and the protective layer 4 may play a role in protecting the touch electrodes located in the display area AA and protecting the bonding area BB.

During implementations, in the above display panel provided by the embodiments of the present disclosure, as shown in FIGS. 4A, 4C, 5A, 5C, 6A, 6C, 7A, 7C and 8, FIG. 8 is a schematic diagram of the boundaries of the first insulating layer 31 and the second insulating layer 33 corresponding to FIGS. 4A, 4C, 5A, 5C, 6A, 6C, 7A and 7C on the upper and lower sides of the bending area CC. It can be seen that the orthographic projections of the first insulating layer 31 and the second insulating layer 33 on the base substrate 11 do not overlap with the orthographic projection of the bending area CC on the base substrate 11, thereby improving the bending performance of the bending area CC.

It should be noted that FIG. 8 is only for the purpose of schematically illustrating the boundaries of the first insulating layer 31 and the second insulating layer 33 on the upper and lower sides of the bending area CC. The first insulating layer 31 and the second insulating layer 33 may be provided with transfer holes in the transition area DD and the wiring area EE.

During implementations, the above display panel provided by the embodiments of the present disclosure, as shown in FIG. 2, further includes: a display structure 13 located between the third planarization layer 133 and the touch structure 3, and an encapsulation structure 2 located between the display structure 3 and the touch structure 3.

The display structure 13 includes an anode layer 134, a pixel definition layer 135, a light-emitting functional layer 136 and a cathode layer 137 stacked in sequence between the third planarization layer 133 and the encapsulation structure 3.

The display panel further includes a spacer layer (not shown) disposed between the pixel definition layer 135 and the cathode layer 137. The material of the spacer is an organic material.

In order to meet the stress requirement of large-angle bending, the encapsulation structure 2 may include a first inorganic encapsulation layer 21, a first organic encapsulation layer 22, a second inorganic encapsulation layer 23, a second organic encapsulation layer 24 and a third inorganic encapsulation layer 25. In this way, compared with the encapsulation structure of inorganic layer-organic layer-inorganic layer in the prior art, the embodiments of the present disclosure can prevent the problem of crack of the second inorganic encapsulation layer 23 when bent by adding the second organic encapsulation layer 24 and the third inorganic encapsulation layer 25, thereby improving the encapsulation performance of the display panel.

21. The display panel according to claim 20, wherein the.

During implementations, in the above display panel provided by the embodiments of the present disclosure, as shown in FIGS. 4B, 4C, 5B, 5C, 6B, 6C, 7A and 7B, in order to further ensure that the first lead 351 is located in the neutral layer 2, the first planarization layer 129, the second planarization layer 131, the third planarization layer 133 and the spacer layer 7 all cover the bending area CC, that is, the first planarization layer 129, the second planarization layer 131, the third planarization layer 133 and the spacer layer 7 are retained in the bending area CC.

During implementations, in the above display panel provided by the embodiments of the present disclosure, as shown in FIGS. 1, 3A, 4A, 5A and 6A, the bonding area BB includes a pad area close to the edge of the display panel. The pad area includes a plurality of pads 8, which are used to bind with the driver IC to transfer signals on the driver IC to the display area AA for display.

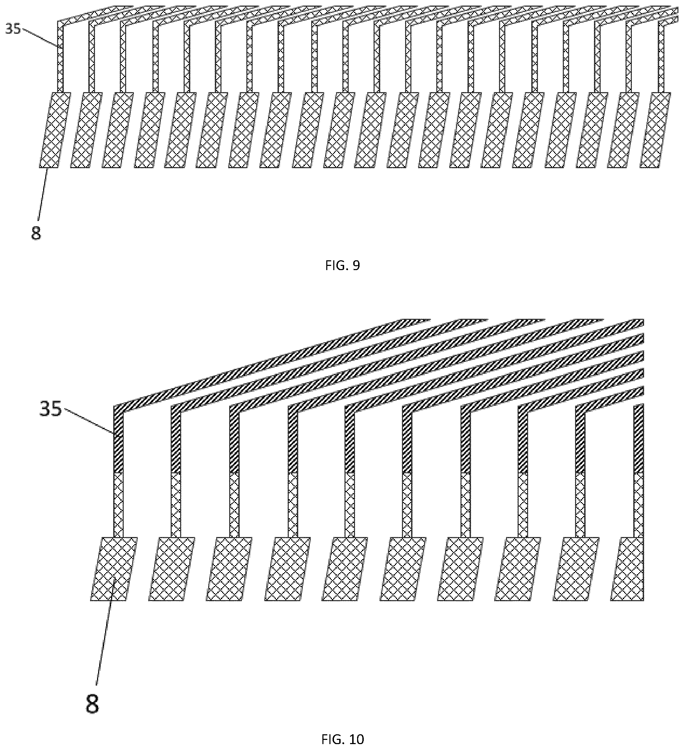

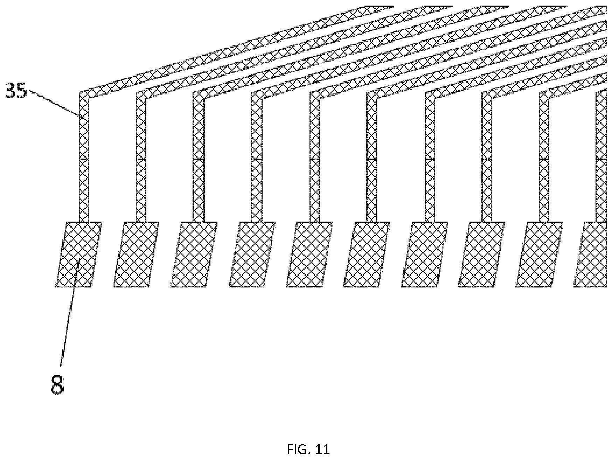

As shown in FIGS. 9, 10 and 11, FIG. 9 is an enlarged schematic diagram of some pads 8 and touch leads 35 electrically connected thereto in FIG. 4A, FIG. 10 is an enlarged schematic diagram of some pads 8 and touch leads 35 electrically connected thereto in FIG. 5A, and FIG. 11 is an enlarged schematic diagram of some pads 8 and touch leads 35 electrically connected thereto in FIG. 6A. The pads 8 may be designed in parallel using a plurality of metal layers among the first metal layer 127, the second metal layer 130, the third metal layer 132, the first touch electrode layer 32 and the second touch electrode layer 34, to reduce the resistance and improve the signal transmission performance.

During implementations, the above display panel according to the embodiments of the present disclosure may also include other functional film layers well known to those skilled in the art, which will not be listed here.

Based on the same inventive concept, embodiments of the present disclosure further provide a display device, including the above display panel provided by the embodiments of the present disclosure. The principle of the display device to solve the problem is similar to that of the above display panel, so the implementations of the display device may refer to the implementations of the above display panel, and the detailed description thereof will be omitted here.

During implementations, the above display device according to the embodiments of the present disclosure may be a full-screen display device or may be a flexible display device, etc., which is not limited here.

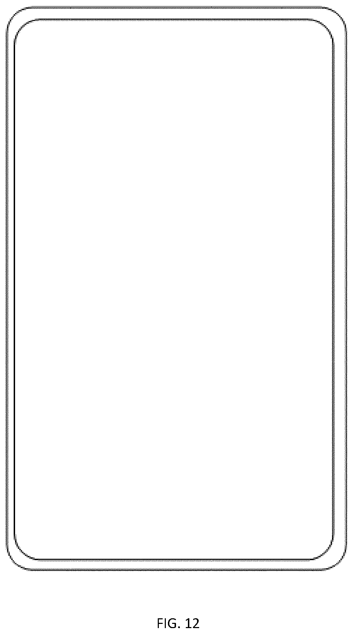

During implementations, the above display device according to the embodiments of the present disclosure may be a full-screen mobile phone as shown in FIG. 12. Of course, the above display device according to the embodiments of the present disclosure may also be a tablet, a television, a display, a laptop, a digital photo frame, a navigator, or any other product or component with display function. All of other indispensable components of the display device should be understood by those ordinary skilled in the art to be included, and will be omitted here and should not be considered as limitations on the present disclosure.

The embodiments of the present disclosure provide a display panel and a display device. In the above display panel provided by the embodiments of the present disclosure, the second lead located in the bonding area is made of the single-layer metal wire, so that the arrangement of a corresponding insulating layer above or below the film layer where the second lead is located can avoid the short problem of adjacent touch leads in the bonding area due to the metal remain in the solution shown in FIGS. 3A to 3C.

Although the preferred embodiments of the present disclosure have been described, those skilled in the art can make additional alterations and modifications to these embodiments once they learn about the basic creative concepts. Thus, the attached claims are intended to be interpreted to include the preferred embodiments as well as all the alterations and modifications falling within the scope of the present disclosure.

Evidently, those skilled in the art can make various modifications and variations to the embodiments of the present disclosure without departing from the spirit and scope of the embodiments of the present disclosure. Thus, the present disclosure is also intended to encompass these modifications and variations to the embodiments of the present disclosure as long as these modifications and variations come into the scope of the claims of the present disclosure and their equivalents.

## Claims

1. A display panel, comprising a display area and a non-display area on a side of the display area, wherein the non-display area comprises a bending area, a bonding area, and a wiring area between the bending area and the bonding area;
the display panel comprises:
a base substrate; and
a touch structure on the base substrate, wherein the touch structure comprises a touch lead led out from the display area and extending to the bonding area; the touch lead comprises a first lead in the bending area and a second lead in the wiring area, the first lead and the second lead are electrically connected and located in different metal layers, and the second lead is made of a single-layer metal wire.

2. The display panel according to claim 1, further comprising a first metal layer, a first planarization layer, a second metal layer, a second planarization layer, a third metal layer and a third planarization layer stacked in sequence between the base substrate and the touch structure, wherein the first metal layer is close to the base substrate;
the touch structure further comprises a first insulating layer, a first touch electrode layer, a second insulating layer and a second touch electrode layer located at least in the display area and stacked in sequence on a side of the third planarization layer facing away from the base substrate;
wherein the first insulating layer and the second insulating layer are organic layers, and the first lead is in the second metal layer.

3. The display panel according to claim 2, wherein the touch lead further comprises a third lead led out from the display area and extending to a side of the bending area away from the bonding area, the third lead comprises a first sub-lead in the first touch electrode layer and a second sub-lead in the second touch electrode layer, and the first sub-lead and the second sub-lead are electrically connected through a via hole penetrating the second insulating layer.

4. The display panel according to claim 3, wherein the non-display area further comprises a transition area between the display area and the bending area, a part of the transition area close to the bending area is a first transfer hole area, and a part of the wiring area close to the bending area is a second transfer hole area; and
the first sub-lead is electrically connected to a first lap-joint portion in the third metal layer through a via hole penetrating the third planarization layer in the first transfer hole area, and the first lap-joint portion is electrically connected to the first lead through a via hole penetrating the second planarization layer in the first transfer hole area.

5. The display panel according to claim 4, wherein the via hole for electrical connection between the first sub-lead and the second sub-lead does not overlap with the first transfer hole area.

6. The display panel according to claim 4 or 5, wherein the second lead is in the third metal layer, and the second lead is electrically connected to the first lead through a via hole penetrating the second planarization layer in the second transfer hole area.

7. The display panel according to claim 6, wherein an orthographic projection of the first touch electrode layer in the wiring area at most covers an orthographic projection of a part of the wiring area close to the bonding area, and an orthographic projection of the second touch electrode layer in the wiring area at most covers the orthographic projection of the part of the wiring area close to the bonding area.

8. The display panel according to claim 7, wherein an orthographic projection of the first touch electrode layer on the base substrate does not overlap with an orthographic projection of the bending area on the base substrate, and an orthographic projection of the second touch electrode layer on the base substrate does not overlap with the orthographic projection of the bending area on the base substrate.

9. The display panel according to claim 4 or 5, wherein the second lead is in the first touch electrode layer, the second lead is electrically connected to a second lap-joint portion in the third metal layer through a via hole penetrating the first insulating layer and the third planarization layer in the second transfer hole area, and the second lap-joint portion is electrically connected to the first lead through a via hole penetrating the second planarization layer in the second transfer hole area.

10. The display panel according to claim 9, wherein an orthographic projection of the first touch electrode layer on the base substrate does not overlap with an orthographic projection of the bending area on the base substrate, an orthographic projection of the second touch electrode layer on the base substrate does not overlap with the orthographic projection of the bending area on the base substrate, and an orthographic projection of the second touch electrode layer in the wiring area at most covers an orthographic projection of a part of the wiring area close to the bonding area.

11. The display panel according to claim 4 or 5, wherein the second lead is in the second touch electrode layer, the second lead is electrically connected to a second lap-joint portion in the third metal layer through a via hole penetrating the second insulating layer, the first insulating layer and the third planarization layer in the second transfer hole area, and the second lap-joint portion is electrically connected to the first lead through a via hole penetrating the second planarization layer in the second transfer hole area.

12. The display panel according to claim 11, wherein an orthographic projection of the second touch electrode layer on the base substrate does not overlap with an orthographic projection of the bending area on the base substrate, an orthographic projection of the first touch electrode layer on the base substrate does not overlap with the orthographic projection of the bending area on the base substrate, and an orthographic projection of the first touch electrode layer in the wiring area at most covers an orthographic projection of a part of the wiring area close to the bonding area.

13. The display panel according to any one of claims 6 to 12, wherein an orthographic projection of the second insulating layer on the base substrate does not overlap with an orthographic projection of the bending area on the base substrate, and the orthographic projection of the second insulating layer on the base substrate overlaps with orthographic projections of the display area, the wiring area and the bonding area on the base substrate.

14. The display panel according to any one of claims 6 to 12, wherein an orthographic projection of the first insulating layer on the base substrate does not overlap with an orthographic projection of the bending area on the base substrate, and the orthographic projection of the first insulating layer on the base substrate overlaps with orthographic projections of the display area, the wiring area and the bonding area on the base substrate.

15. The display panel according to any one of claims 2 to 14, further comprising a low-voltage power line and a high-voltage power line, wherein the low-voltage power line and the high-voltage power line in the bending area are both made of single-layer metal wires in the second metal layer, and the metal wires of the low-voltage power line and/or the high-voltage power line in the bending area are located on both sides of the first lead and spaced apart from the first lead; and
the low-voltage power line and the second lead overlap with each other in the wiring area.

16. The display panel according to any one of claims 6 to 8, further comprising a low-voltage power line and a high-voltage power line, wherein the low-voltage power line comprises a first conductive structure and a second conductive structure in the wiring area, the first conductive structure is in the first metal layer, the second conductive structure is in the second metal layer, and the first conductive structure is electrically connected to the second conductive structure through a via hole penetrating the first planarization layer; and
the high-voltage power line comprises a third conductive structure and a fourth conductive structure in the wiring area, the third conductive structure is in the first metal layer and spaced apart from the first conductive structure, the fourth conductive structure is in the second metal layer and spaced apart from the second conductive structure, and the third conductive structure is electrically connected to the fourth conductive structure through a via hole penetrating the first planarization layer.

17. The display panel according to claim 16, wherein the low-voltage power line further comprises a fifth conductive structure in the wiring area, the fifth conductive structure is in the third metal layer, and the fifth conductive structure is electrically connected to the second conductive structure through a via hole penetrating the second planarization layer;
the high-voltage power line further comprises a sixth conductive structure in the wiring area, the sixth conductive structure is in the third metal layer and spaced apart from the fifth conductive structure, and the sixth conductive structure is electrically connected to the fourth conductive structure through a via hole penetrating the second planarization layer;
the second lead is insulated from the fifth conductive structure and the sixth conductive structure.

18. The display panel according to claim 17, wherein the fifth conductive structure comprises two sub-conductive structures spaced apart from each other, and the second lead is between the two sub-conductive structures.

19. The display panel according to any one of claims 1 to 18, further comprising a protective layer on a side of the touch structure facing away from the base substrate, wherein an orthographic projection of the protective layer on the base substrate does not overlap with an orthographic projection of the bending area on the base substrate.

20. The display panel according to any one of claims 2 to 19, further comprising: a display structure between the third planarization layer and the touch structure, and an encapsulation structure between the display structure and the touch structure;
the display structure comprises an anode layer, a pixel definition layer, a light-emitting functional layer and a cathode layer stacked in sequence between the third planarization layer and the encapsulation structure;
the display panel further comprises a spacer layer disposed between the pixel definition layer and the cathode layer; and
the encapsulation structure comprises a first inorganic encapsulation layer, a first organic encapsulation layer, a second inorganic encapsulation layer, a second organic encapsulation layer and a third inorganic encapsulation layer stacked.

21. The display panel according to claim 20, wherein the first planarization layer, the second planarization layer, the third planarization layer and the spacer layer all cover the bending area.

22. A display device, comprising the display panel according to any one of claims 1 to 21.
